# EUROPEAN PATENT SPECIFICATION

(11) **EP 1 057 768 B1**
(45) Date of publication and mention of the grant of the patent: **07.03.2007**
(21) Application number: 98961597.6
(22) Date of filing: 25.12.1998
(51) Int. Cl.: B66B 1/34, H05K 7/20, B66B 7/00

(54) **ELEVATOR CONTROL APPARATUS**
AUFZUGSSTEUERUNGSGERÄT
APPAREIL DE COMMANDE D'ASCENSEUR

(43) Date of publication of application: 06.12.2000
(73) Proprietor: MITSUBISHI DENKI KABUSHIKI KAISHA, Chiyoda-ku Tokyo 100-8310 (JP)
(72) Inventor: ISHIKAWA, Masahiro, Mitsubishi Denki K. K., Tokyo 100-8310 (JP); YAMAKAWA, Shigeki, Mitsubishi Denki K. K., Tokyo 100-8310 (JP); SUZUKI, Satoshi, Mitsubishi Denki K. K., Tokyo 100-8310 (JP)
(74) Representative: HOFFMANN EITLE
(86) International application number: PCT/JP1998/005953
(87) International publication number: WO 2000/039014

(56) References cited:
- JP-A- 2 301 192
- JP-A- 3 018 569
- JP-A- 4 283 723
- JP-A- 4 338 074
- JP-A- 9 068 375
- JP-A- 9 181 471
- JP-A- 62 265 798
- JP-U- 5 015 487
- PATENT ABSTRACTS OF JAPAN vol. 010, no. 187 (M-493), 2 July 1986 (1986-07-02) & JP 61 030414 A (HITACHI CABLE LTD), 12 February 1986 (1986-02-12)

## Description

### BACKGROUND OF THE INVENTION

### 1. Field of the Invention

The present invention relates to an elevator controlling apparatus for controlling operation of an elevator.

### 2. Description of the Related Art

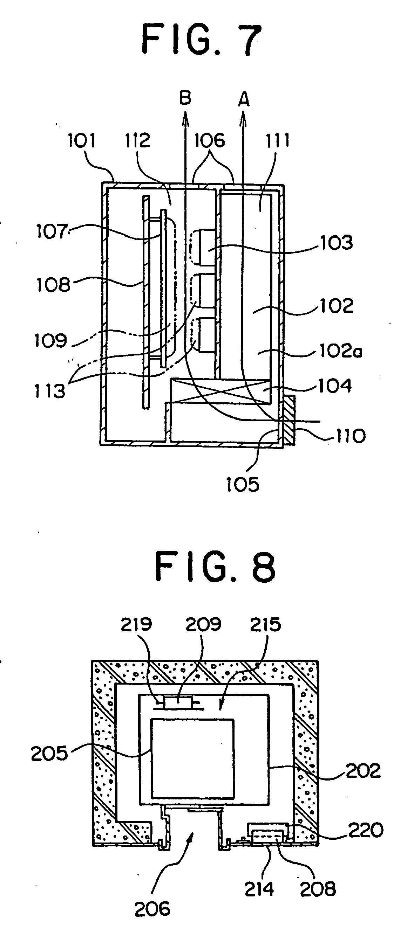

The invention disclosed in Japanese Patent Application Laid-Open No. Hei 4-338074 will first be described as a conventional elevator controlling apparatus with reference to Fig. 7.

In Fig. 7, a heating part 103 such as a high power semiconductor is mounted on a heat radiating fin 102 or the like in each electric part for controlling the operation of an elevator disposed in a box 101 of the elevator controlling apparatus. A cooling fan 104 is disposed at a suitable position for cooling each electric part or the like mounted on the heat radiating fin 102 or a whole heat radiating portion 102a of the heat radiating fin 102. An air flow A for cooling the heat radiating portion 102a of the heat radiating fin 102 as a whole is introduced from a cooling air flow inlet 105 and fed to a cooling air vent 106 through a first cooling air passage 111. At the same time, an air flow B for cooling each electric part mounted on the heat radiating fin 102 is introduced from the cooling air flow inlet 105 and fed to the cooling air vent 106 through a second cooling air passage 112.

Note that, in the drawing, reference numeral 107 denotes a printed circuit board, numeral 108 denotes a mounting plate, numeral 109 denotes each mounting part, and numeral 113 denotes a snubber composed of a resistor, a capacitor and the like mounted on the heating part 103 for suppressing a surge voltage generated when the high power semiconductor element performs a switching operation.

Next, Fig. 8 shows an arrangement example of the elevator controlling apparatus in an elevator system disclosed in Japanese Patent Application Laid-Open No. Hei 3-18569. In the drawing, numeral 208 denotes a main control panel disposed in a rear portion of an inspection door 214 on the upper right side of a floor in the drawing. Reference numeral 209 denotes an auxiliary control panel mounted on an inner wall of an elevator hoistway 202 as the elevator controlling apparatus in the same manner. Recently, like this arrangement example, this kind of elevator controlling apparatus is disposed in a limited space in response to the requirement of reducing the space to install the elevator system. Accordingly, there is a demand that the apparatus be thinned.

In the conventional elevator controlling apparatus, as in the above-described conventional examples, based on the concept to enhance the cooling effect by directing the blow of the cooling fan directly to the heating part when the heating part disposed in the box of the apparatus is to be cooled, a rotary shaft of the arrangement of the cooling fan is directed to the heating part. Namely, as in the conventional example shown in Fig. 7, since the cooling blow is directed from above downwardly to the heating part disposed in the inner side surface of the box of the controlling apparatus formed longitudinally the rotary shaft of the cooling fan is arranged to be directed upwardly vertically.

However, as shown in Fig. 8, in the recent elevator system, a machine room is dispensed with or such a controlling apparatus is disposed in a limited space such as the inner wall of the hoistway of the elevator. Thus, there is a strong demand to a space-saving of the installation place for the elevator system.

Nevertheless, according to the conventional concept, in order to feed the blow directly to the heating part disposed in the interior of the longitudinal box, it is by no means necessary to direct the rotary shaft of the cooling fan upwardly vertically. As a result, it is impossible to reduce a thickness (depth) of the box of the controlling apparatus to be less than a diameter of the cooling fan. Accordingly, it is difficult to thin the box, i.e., the elevator controlling apparatus. It is also difficult to arrange the apparatus in the limited small space such as the hoistway of the elevator.

Also, if the thin type cooling fan having the short rotary shaft is to be arranged with its rotary shaft horizontally, there is a disadvantage that the cooling blow of the fan is not directed to the heating part disposed in the longitudinal box, and in addition, the flow of the air within the box is not smooth, resulting in degradation in cooling effect.

### SUMMARY OF THE INVENTION

In order to overcome the above-noted problem, an object of the present invention is to provide a thin type elevator controlling apparatus that is superior in cooling ability.

According to the present invention, in an elevator controlling apparatus with a box formed longitudinally, an intake port is provided as an air introducing port on a lower side of the box, a discharge outlet is provided as an air discharging port within the box on an upper side of the box, a heat radiating fin of heat pipes arranged within the box faces the discharge outlet, furthermore, a discharge fan is arranged so as to discharge the air within the box from the vent while colliding it against the heat radiating fin, and a heating part is arranged in the box along an air passage along with the air sucked from the intake port flows to the discharge fan. Thus, it is possible to provide the elevator controlling apparatus that is superior in cooling ability.

### BRIEF DESCRIPTION OF THE DRAWINGS

In the accompanying drawings:
Fig. 1 is a horizontal cross-section of a hoistway through which the elevator car moves up and down;
Fig. 2 is an outer perspective view showing an elevator controlling apparatus according to the present invention;
Fig. 3 is a longitudinal sectional view of the elevator controlling apparatus according to the present invention;
Fig. 4 is an enlarged perspective view of a primary part of the elevator controlling apparatus according to the present invention;
Fig. 5 is an outer perspective view of an elevator controlling apparatus according to another embodiment;
Fig. 6 is a longitudinal sectional view showing the elevator controlling apparatus shown in Fig. 5;
Fig. 7 is a longitudinal sectional view showing a conventional elevator controlling apparatus; and
Fig. 8 is a horizontal sectional view, showing a mounted condition of the conventional elevator controlling apparatus.

### DETAILED DESCRIPTION OF THE PREFERRED EMBODIMENTS

A preferred embodiment of the present invention will now be described with reference to the drawings.

### Embodiment 1

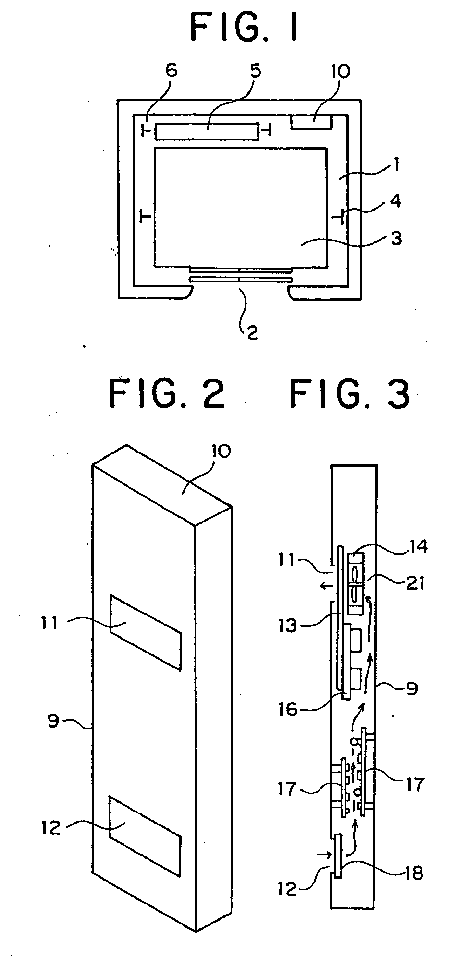

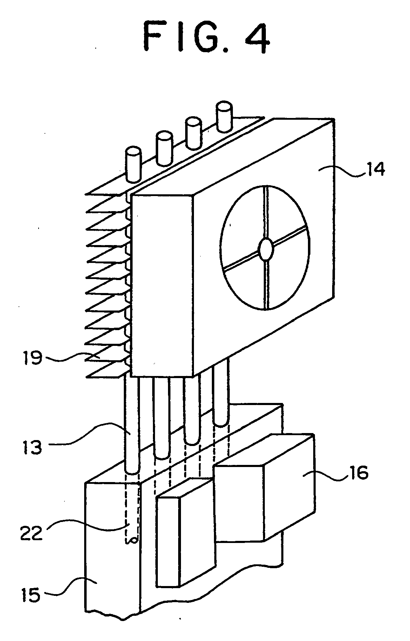

Fig. 1 is a horizontal cross-sectional view of a hoistway through which the elevator moves up and down. Fig. 2 is an outer perspective view of the elevator controlling apparatus according to the present invention. Fig. 3 is a vertical cross-sectional view and Fig. 4 is an enlarged perspective view of the primary part. In Figs. 1 through 4, reference numeral 1 denotes the hoistway, numeral 2 denotes a riding place, numeral 3 denotes a car where the passenger rides, numeral 4 denotes guide rails for guiding the up-and-down movement of the elevator, numeral 5 denotes a counterweight for balancing with the weight of the elevator, numeral 6 denotes guide rails for guiding the up-and-down movement of the counterweight, and numeral 10 denotes the elevator controlling apparatus mounted on an inner wall of the hoistway 1.

The construction of the elevator controlling apparatus according to the embodiment 1 will now be described.

Since a box 9 of the elevator controlling apparatus 10 is to be mounted on, for example, the inner wall surface of the hoistway 1, the apparatus is long in vertical direction in comparison with its width so that it is formed into a longitudinal thin type where the depth (thickness) is small. A vent 11 used as an air-vent within the box 9 is formed on the upper portion of the box 9. Also, an intake port 12 used as an air introducing inlet is formed on the lower side of the box 9 away from the vent in the vertical direction.

In this example, under the condition that the vent 11 or the surface of the box 9 of the intake port 12, i.e., the box 9 is mounted on the wall surface of the hoistway 1, it is provided on the surface directed toward the elevator. However, it is not always necessary to mount it on the surface. According to the arrangement to set up the circumstances, it is possible to provide the vent 11 on the rear side of the box 9 or it is possible to provide the intake port 12 on the lower side of the box 9. The position may be selected from any one of the rear surface, side surface or bottom surface of the box 9.

In the drawing, reference numeral 13 denotes heat pipes disposed within the box 9. The heat pipes 13 are disposed so as to cover the above-described vent 11 from its inside with the heat radiating fin 19. The discharge fan 14 is disposed on the heat radiating fin 19 to face the heat radiating fin 19 so that the air within the box 9 is brought into abutment with the heat radiating fin 19 and discharged from the vent 11.

In this example, the vent 11 and the heat radiating fin 19 are caused to face to each other so that the ventilated air from the discharge fan 14 is exhausted from the vent 11. The discharge fan 14 is disposed with its rotary shaft being directed in the perpendicular direction to the parallel surface of the vent 11 and the heat radiating fin 19.

However, the discharge fan 14 is not always perpendicular to the parallel surface with the heat radiating fin 19 and the vent 11. For example, a duct (not shown) may be provided from the discharge fan 14 to the vent 11. In brief, the discharge fan may be disposed under the condition its rotary shaft is slanted relative to the parallel surface with the vent 11 and the heat radiating fin 19 as far as the air within the box 9 may be discharged effectively.

The shorter the rotary shaft of the discharge fan 14, the smaller the length from the surface of the vent 11 (the surface of the box 9) to the rear surface of the discharge fan 14 (on the rear side of the interior of the box 9), i.e., the thickness of the overlap between the vent 11, the heat radiating fin 19 and the discharge fan 14 may become. Accordingly, it is possible to reduce the depth (thickness) of the box 9.

Each electric part constituting the elevator controlling apparatus 10 is disposed within the box 9. In the electric parts, a variety of heat generating parts to be cooled, i.e., heat generating elements such as a power module constituting an inverter for driving a motor for moving the car 3 up and down, a controlling substrate or the like and/or a printed circuit board 17 or the like that is slightly heated up are arranged so that the blow sucked from the intake port 12 flows along a passage 21 to the discharge fan 14.

The operation will now be described.

Since the air within the box 9 is discharged from the vent 11 by the action of the discharge fan 14, the air within the hoistway 1 flows into the box 9 from the intake port 12. When the introduced air (cooling air) moves upwardly along the box 9, the various heat generating parts 16 and 17 arranged along the air passage 21 for the rising air are cooled.

The rising force of the heated air (warm air) by the heating parts 16 and 17 is further strengthened because its specific weight becomes small. Accordingly, the introduction of fresh air (cool air) from the intake port 12 is accelerated.

On the other hand, the rising air reaches between the discharge fan 14 and the rear surface of the box 9, and will be discharged to the outside of the box 9 from the vent 11 while cooling the heat radiating fin 19 of the heat pipes 13.

The heating part 16 to be cooled is disposed in contact with the heat pipes 13 in the lower portion of the above-described heat pipes 13 so that the heat of the heating pat 16 is transferred to the heat pipes 13. The heat medium sealed within the heat pipes 13 is subjected to the heat of the heating part 16 and rises toward the heat radiating fin 19 and in turn cooled by the air sprayed to the heat radiating fin 19 by the discharge fan 14 to be lowered to the lower portion of the heat pipes 13 again.

Since the box 9 where the variety of controlling devices are disposed is formed into a chimney shape where the vent 11 is provided on the upper side of the longitudinal thin form and the intake port 12 is provided on the lower side, the rising air flow may readily be formed within the box 9.

Accordingly, the heat generated by the heating part 16 may be cooled down very effectively by the rising air flow within the box 9 generated by the discharge fan 14, the endothermic action and the heat recirculation by the heat medium within the heat pipes 13, and the forcible cooling by the discharge fan 14 for the heat radiating fin 19 of the heat pipes 13.

According to the first embodiment, since the heat pipes 13 are arranged so that it is flush with the discharge fan 14 and its air flow direction is perpendicular to the surface of the surface of the box 9, the thinning tendency of the controlling apparatus is not prevented and the cooling ability may be enhanced.

Also, the diameter and the dimension of the discharge fan 14 only affect the width of the box 9 but the depth (thickness) of the box 9 is not subjected to any adverse affect. Accordingly, using the discharge fan having a predetermined diameter may enhance the cooling ability. On the other hand, it is possible to reduce the depth of the elevator controlling apparatus.

Also, the box 9 per se of the elevator controlling apparatus is utilized as the duct through which the air flows and is formed into the chimney-shaped structure in which the air may readily flow from the intake port 12 on the lower side of the box 9 to the vent 11 on the upper side. Not only the heating part 16 disposed in the air passage 21 or the heating part 16 in intimate contact with the cooling base 15 or the heat pipes 13 to be described later but also the other heating part 16 that is in intimate contact with or out of contact with the heat pipes 13 or the cooling base 15 or the various devices such as the plate substrate 17 that slightly generates the heat is disposed in the air passage from the intake port 12 to the vent 11. With such a simple structure, it is possible to accelerate the generation of the rising air within the box to increase the flow rate of the air and to exhibit the remarkable cooling effect by the endothermic action of the air that passes through the air passage 21.

Also, since it is possible to achieve the thin type elevator controlling apparatus that is superior in cooling ability as described above, particularly on a wall surface of the hoistway, on the back side of a shutter box in the riding place or the like where the installation space is limited or in an elevator system that has no machine room, it is possible to readily install the controlling apparatus by utilizing the gap space or the limited space. Also, its installation property is superior.

The heat pipes 13 will now be described with reference to Fig. 4.

The heat pipes 13 shown in this embodiment is provided on the upper side with the heat radiating fin 19 and on the lower side with the cooling base 15.

The heat radiating fin 19 composed of a number of fin elements is provided on the portion of the heat pipes 13 extending between the vent 12 and the discharge fan 14. The air of the discharge fan 14 is caused to collide with the heat radiating fin 19 to thereby enhance the cooling efficiency of the heat pipes 13.

On the other hand, the heating part 16 is arranged in intimate contact with the cooling base 15 so that the heat of the heating part 16 is absorbed through the cooling base 15 to the inner heat medium (not shown) to cool the heating part 16.

This cooling base 15 enhances the heat transfer efficiency between the heating part 16 and the heat pipes 13. The heat radiation of the heating part 16 disposed within the compact thin box 9 is transferred quickly through the heat pipes 13 and the heat radiating fin 19 to the vent 11 to thereby make it possible to suppress the temperature elevation within the box 9 effectively.

The cooling base 15 shown is formed into a plate shape having a certain thickness. Joint holes 22 are formed in the top end face of the plate board, into which the lower ends of the heat pipes 13 are inserted for the connection.

The cooling base 15 needs a thickness to some extent for effectively transferring the heat of the heating part 16 and for mounting the heating part 16 thereon. In this example, this thickness is utilized; that is, the joint holes 22 are provided over the thickness width and the base is connected to the lower ends of the heat pipes 13. Therefore, although the box 9 is of a thin type, it is possible to keep a space to mount the heating part 16 to be mounted on the cooling base 15 within the box 9, while the passage of the air flow for cooling extending from the intake port 12 to the heat radiating fin 19, i.e., the air passage 21 can be kept broader.

### Embodiment 2

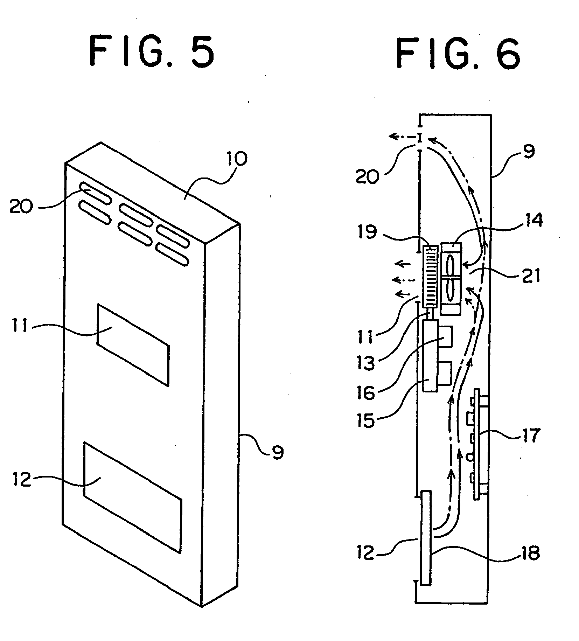

Fig. 5 is an outer perspective view showing an elevator controlling apparatus in accordance with embodiment 2. Fig. 6 is a vertical cross-sectional view thereof. In the figure, the same reference numerals are used to indicate the same or like components as those of the above-described embodiment 1 and explanation therefor will be omitted.

The elevator controlling apparatus 10 shown in Figs. 5 and 6 is provided with a ventilation port 20 formed in the upper side above the vent 11 of the box 9 in addition to the structure of the embodiment 1.

This ventilation port 20 is a simple ventilation port for naturally discharging the warm air rising within the box 9. Also, in the example shown, the ventilation port 20 is provided in the top surface of the box 9. However, the arrangement thereof is not limited thereto but it is possible to provide the port in the end face of the upper portion of the box 9 or in the side surface of the upper portion or in the back surface.

The operation will now be described.

When the discharge fan 14 works normally, the outside air (cooling air) is introduced from the intake port 12 into the box 9 to cool the heating part 16. The air that absorbs the heat from the heating part 16 becomes the warm air to rise within the box 9. The thus rising air (warm air) from the lower portion of the box 9 and outside air (cooling air) introduced from the ventilation port 20 in the upper portion of the box 9 that is kept under the negative pressure by the action of the discharge fan 14 are merged together in the discharge fan 14 so that the heat pipes 13 are cooled down. The discharge fan 14 can therefore more effectively cool the heat pipes 13 than the case where the heat pipes 13 are cooled only with the air rising within the box 9.

Also, even if the discharge fan 14 is stopped due to any reason, in the box 9 that is formed in a longitudinal type having the duct function, the air (warm air) gathering in the upper portion is naturally discharged from the ventilation port 20 by the chimney effect extending longitudinally up and down. The rising airflow is generated within the box 9, and the natural cooling effect is performed within the box 9 by the outside air (outer air) newly introduced from the intake port 12.

Also, the heating part 16 within the box 9 is disposed below the vent 11. The space above the vent 11 is kept relatively broad; that is, the upper portion side of the box 9 is longer. Then, the ventilation port 20 is provided in the longer portion to thereby make the temperature gradient remarkable within the box 9. Various devices such as heating part 16 disposed on the lower side are set in the lower environmental temperature, to thereby further enhance the cooling efficiency within the box 9.

According to the present invention, since it is possible to reduce the thickness of the overlap of the vent , the heat radiating fin and the discharge fan, it is possible to provide a thin type elevator controlling apparatus with a box having a small depth (thickness).

Also, the heat generated within the box is suppressed by the rising airflow within the box caused by the discharge fan, the endothermic action and the thermal recirculation by the heat medium of the heat pipes and the forcible cooling action by the discharge fan onto the heat radiating fin. Accordingly, it is possible to provide an elevator controlling apparatus that is excellent in heat cooling efficiency.

Also, since the box per se is utilized as the duct through which the air passes, with a simple arrangement of various devices in the air passage extending from the intake port to the discharge outlet, the generation of the rising air flow within the box is strongly promoted to increase the flow rate to thereby enhance the cooling effect.

Also, since it is possible to obtain a thin type elevator controlling apparatus that is superior in cooling ability as described above, it is possible to readily install the controlling apparatus on a wall surface of a machine room, in particular on a wall surface of the hoistway or on the back side of a shutter box in the riding place or the like where the installation space is limited utilizing the existing gap space or the limited space in an elevator system that has no machine room.

Also, according to the present invention, the cooling base of the heat pipes is formed into a plate shape having a certain thickness to enhance the heat transfer property, while the certain thickness is utilized to form the joint holes into which the lower ends of the heat pipes are inserted for the connection. Therefore, although the box is of the thin type, it is possible to keep the space to mount the heating part broader on the cooling base and it is also possible to keep the passage wider within the box.

Also, according to the present invention, the air from the ventilation port provided in the upper portion of the box is merged into and mixed with the air (warm air) rising within the box in the discharge fan to cool the heat pipes. Accordingly, it is possible to more effectively cool the heat pipes than the case where the heat pipes are cooled only by the rising warm air within the box.

Also, since the ventilation port is provided on the upper side of the box, even if the discharge fan is out of order, it is possible to effect the natural cooling action within the box.

## Claims

1. An elevator controlling (10) apparatus with a box (9) elongated in a vertical direction, comprising:
an intake port (12) provided in a lower side of said box (9);
a discharge port (11) provided in an upper side of said box (9);
heat pipes (13) disposed with heat radiating fins (19) facing said discharge port (11);
a discharge fan (14) arranged so that an air flow is discharged through the heat radiating fins (19) from said discharge port (11); and
heat-generating components (16) that are arranged along an air passage (21) along which the air flow sucked from said intake port (12) flows to said discharge fan (14).

2. An elevator controlling apparatus according to claim 1, wherein said discharge port (11), said heat radiating fins (19) of said heat pipes (13) and said discharge fan (14) are overlapped with each other in a direction of extension of a rotary shaft of said discharge fan (14).

3. An elevator controlling apparatus according to claim 1, wherein said heat-generating components (16) are arranged along the air passage (21) extending from said intake port (12) to said discharge fan (14).

4. An elevator controlling apparatus according to claim 1, wherein heat-generating components (16) are not in contact with a cooling base (15) of said heat pipes (13) and arranged along the air passage (21) extending from said intake port (12) to said discharge fan (14).

5. An elevator controlling apparatus according to claim 1, wherein a ventilation port (20) is provided in the box above said discharge port (11).

## Patentansprüche

1. Aufzug-Steuervorrichtung (10) mit einem in einer vertikalen Richtung verlängerten Kasten (9), umfassend:
eine Einlass-Öffnung (12), die in einer unteren Seite des Kastens (9) bereitgestellt ist;
eine Austritts-Öffnung (11), die in einer oberen Seite des Kastens (9) bereitgestellt ist;
Wärmerohre (13), die mit Wärmestrahlungs-Rippen (19) versehen sind, die der Austritts-Öffnung (11) gegenüberliegen;
ein Austritts-Gebläse (14), das derart angeordnet ist, dass ein Luftstrom über die Wärmestrahlungs-Rippen (19) aus der Austritts-Öffnung (11) herausströmt; und
Wärme erzeugende Komponenten (16), die entlang eines Luftdurchlasses (21) angeordnet sind, wobei der von der Einlass-Öffnung (12) angesaugte Luftstrom entlang des Luftdurchlasses (21) zu dem Austritts-Gebläse (14) strömt.

2. Aufzug-Steuervorrichtung nach Anspruch 1, wobei die Austritts-Öffnung (11), die Wärmestrahlungs-Rippen (19) der Wärmerohre (13) und das Austritts-Gebläse (14) in einer Richtung der Erstreckung einer Welle des Austritts-Gebläses (14) überdeckend zueinander angeordnet sind.

3. Aufzug-Steuervorrichtung nach Anspruch 1, wobei die Wärme erzeugenden Komponenten (16) entlang des Luftdurchlasses (21) angeordnet sind, der sich von der Einlass-Öffnung (12) zu dem Austritts-Gebläse (14) erstreckt.

4. Aufzug-Steuervorrichtung nach Anspruch 1, wobei die Wärme erzeugenden Komponenten (16) keinen Kontakt mit einem Kühl-Sockel (15) der Wärmerohre (13) aufweisen und entlang des Luftdurchlasses (21) angeordnet sind, der sich von der Einlass-Öffnung (12) zu dem Austritts-Gebläse (14) erstreckt.

5. Aufzug-Steuervorrichtung nach Anspruch 1, wobei in dem Kasten eine Entlüftungs-Öffnung (20) über der Austritts-Öffnung (11) bereitgestellt ist.

## Revendications

1. Appareil de commande d'ascenseur (10) ayant une boîte (9) allongée dans une direction verticale, comportant:
un orifice d'admission (12) agencé d'un côté inférieur de ladite boîte (9),
un orifice d'évacuation (11) agencé d'un côté supérieur de ladite boîte (9),
des tubes de chaleur (13) munis d'ailettes rayonnant de la chaleur (19) en vis-à-vis dudit orifice d'évacuation (11),
un ventilateur d'évacuation (14) agencé de sorte qu'un écoulement d'air est évacué, à travers les ailettes rayonnant de la chaleur (19), à partir dudit orifice d'évacuation (11), et
des composants générant de la chaleur (16) qui sont agencés le long d'un passage d'air (21) le long duquel l'écoulement d'air aspiré à partir dudit orifice d'admission (12) s'écoule vers ledit ventilateur d'évacuation (14).

2. Appareil de commande d'ascenseur selon la revendication 1, dans lequel ledit orifice d'évacuation (11), lesdites ailettes rayonnant de la chaleur (19), desdits tubes de chaleur (13) et ledit ventilateur d'évacuation (14) se recouvrent mutuellement dans une direction de prolongement d'un arbre rotatif dudit ventilateur d'évacuation (14).

3. Appareil de commande d'ascenseur selon la revendication 1, dans lequel lesdits composants générant de la chaleur (16) sont agencés le long dudit passage d'air (21) s'étendant depuis ledit orifice d'admission (12) jusqu'audit ventilateur d'évacuation (14).

4. Appareil de commande d'ascenseur selon la revendication 1, dans lequel les composants générant de la chaleur (16) ne sont pas en contact avec une base de refroidissement (15) desdits tubes de chaleur (13) et sont agencés le long du passage d'air (21) s'étendant depuis ledit orifice d'admission (12) jusqu'audit ventilateur d'évacuation (14).

5. Appareil de commande d'ascenseur selon la revendication 1, dans lequel un orifice de ventilation (20) est agencé dans la boîte au-dessus dudit orifice d'évacuation (11).
